# EUROPEAN PATENT APPLICATION

(11) **EP 4 257 723 A1**
(43) Date of publication of application: **11.10.2023**
(21) Application number: 22305449.5
(22) Date of filing: 04.04.2022
(51) Int. Cl.: C23C 16/04, C23C 16/455, C23C 16/458, C23C 16/54, H01L 39/24

(54) **UNIFORM COATING OF A SURFACE**

(71) Applicant: Renaissance Fusion, 38600 Fontaine (FR)
(72) Inventor: VOLPE, Francesco, 38600 FONTAINE (FR); KOCHAT, Mehdi, 38600 FONTAINE (FR)
(74) Representative: Cabinet Beaumont

(57) **Abstract**

The present disclosure relates to a method for coating a surface (110B) of a structure (110), the method comprising steps of:
- placing a structure (110) inside a chamber, at least one ejector (104) being located inside the chamber and oriented towards a surface (110B) to be coated of the structure;
- enclosing the chamber;
- forming a vacuum in the chamber; and then
- injecting vapor through the at least one ejector (104) towards the surface, while causing a relative motion, for example rotation, between the structure and the at least one ejector.

## Description

### Technical field

The present disclosure is related to uniform coating of a surface. More particularly, it is related to coating of a surface through the use of a vapor. The surface may be an inner or an outer surface of a structure, for example a cylinder in its broader definition, that is, a surface in space made of parallel straight lines (generating lines).

### Background art

The challenges of the 21st century must be met with technology that pushes the current boundaries of science. Energy generation from fusion power, medical procedures like magnetic resonance imaging machines and transportation system like magnetic levitation trains, among many others, all have in common that they require strong magnetic fields in specific configurations to function properly. Therefore, the world of the future will require methods, devices and mechanisms that can produce strong magnetic fields and that meet the demands of a growing sector.

The latest developments in magnetic fields make use of High-Temperature Superconductors HTS. HTS are materials that exhibit superconducting properties at temperatures generally above 77 K, the boiling point of nitrogen. HTS materials exhibit a resistance of zero under the superconducting circumstances, which is usually a matter of being at the right temperature. Having zero resistance, currents can flow freely and at high intensity through these superconducting materials. Ultimately this makes it possible to produce magnetic fields of high strength and with specific characteristics as required by the application.

Presently, magnetic devices are constructed with large magnets that are shaped into the form of a coil; magnets may be either permanent or electrical depending on cost or application. In applications where the field needs a special configuration, for instance, in stellarators, the coil must be twisted to a complicated shape during construction. This greatly increases costs during the design phase; stellarator design is very complicated and requires a lot of testing, so constructing many magnets coils requires a lot of time and of money.

A document dealing with the construction of superconducting coils is U.S. Pat. No. 9,812,233 to Sazaki, et. al., which describes the current state of the art concerning the construction of superconducting material films, also described as tapes. The current state of the art considers producing tapes which are stacked to form a cable like structure. This cable like structure is then shaped according to the needs of the application. It may be cut to shape, twisted, stacked or otherwise.

A method for constructing superconducting coils is described in U.S. Pat. No. 8,655,423 to Miyazaki, et al. Miyazaki describes a superconducting coil formed of several layers of different materials. A group of these layers is described as constituting a superconducting coil portion which is formed of thin-film superconducting wires. The coils described by Miyazaki and those that are common in the art are constructed by arranging superconducting films, also called superconducting tapes, into the shape of wires and the wires are then further configured into the shape of coils. According to a review of the prior art, superconducting coils are formed by stacking superconducting films or layers so that electric current may flow in a desired direction and produce the appropriate magnetic field configuration.

To the best knowledge and understanding of the inventors, the prior art doesn't teach any other method by which the superconducting films or tapes may be used to conduct a current.

The tapes themselves can be constructed through several methods described in the art. In US Pat. No. 10, 935, 799 to Majkic, et al. a method for fabricating high quality superconducting tapes is disclosed. The method of Majkic is limited to applications that require a very thin tape structure. It is not apparent from the description of Majkic how the process may defeat the limitations of, for example, different tape geometries. The method described in this prior art is limited to the rectangular shape of the appropriate size.

An apparatus and method for forming a film on a tape substrate is disclosed in US. Pat. No. 6,147,033 to Youm et al. This apparatus further exemplifies the limitations of the current methods in the state of the art. A thin film of superconducting material is deposited on a rolling cylinder, that unwinds a tape substrate, thus forming the tape. This method does not allow for a different shape than that of a rectangular tape. Further, if the tape is left for an inordinate amount on tape on the rolling cylinder, the whole tape could be damaged.

Superconducting tapes themselves are also in short supply, as their demand is high. There is also the problem of the size and shape of the tapes which can only be constructed a few centimeters wide. In addition, the process that arranges the tapes into wires and further into coils is lengthy and error prone.

Thus, there remains a need for an efficient and less costly alternative to the coils that are used in magnetic applications. Further, there is a need for a method or device that allows for the construction of superconducting coils that can be easily interchanged, so that configuration changes may be realized quickly and at a little cost. The prior art is yet to overcome the limitation of producing superconducting tapes of any shape or size, currently shapes are limited to rectangular geometries.

### Summary of Invention

One embodiment addresses all or some of the drawbacks of known method or device for constructing superconducting coils.

One embodiment provides a method for coating a surface of a structure, the method comprising steps of:
- placing a structure inside a chamber, at least one ejector being located inside the chamber and oriented towards a surface to be coated of the structure;
- enclosing the chamber;
- forming a vacuum in the chamber; and then
- injecting vapor through the at least one ejector towards the surface, while causing a relative motion, for example rotation, between the structure and the at least one ejector.

In one embodiment, a material, for example a precursor, is evaporated to form the vapor, before the injection step.

In one embodiment, the method further comprises heating the surface of the structure, preferably at a first temperature, preferably a high temperature, for example higher than 500°C.

In one particular embodiment, a buffer layer is located on the surface, the buffer layer being heated at the first temperature.

In one embodiment, the velocity of the motion, for example rotation, is adapted to creating a laminar flow of the vapor near the surface in the chamber.

In one embodiment, causing a relative motion between the structure and the ejector comprises, for example consists in, rotating said structure.

In one embodiment, the vapor is injected at a direction substantially parallel to the surface of the structure, and/or wherein the vapor is injected at a direction oblique, for example substantially radially, to the surface of the structure.

One embodiment provides a device for coating a surface of a structure, adapted to implement the method of an embodiment, wherein the device comprises:
- a chamber adapted to contain the structure;
- at least one ejector located inside the chamber and oriented towards a surface to be coated of the structure, the ejector being adapted to injecting vapor towards said surface; and
- a motion apparatus adapted to cause a relative motion, for example rotation, between said structure and the at least one ejector.

In one embodiment, the device comprises a first and/or second support contained in the chamber or forming at least part of the chamber, and adapted to support the at least one ejector, the first and/or second support being for example a cylinder.

In one embodiment, the surface to be coated is an outer surface of the structure, the device comprises a first support adapted to contain the structure, and an ejector of the at least one ejector is positioned on an inner surface of the first support.

In one embodiment, the first support forms at least part of the chamber, for example the first support comprises at least a base adapted to be closed in order to enclose the structure inside said first support.

In one embodiment, the surface to be coated is an inner surface of the structure, the device comprises a second support adapted to be placed inside the structure, and an ejector of the at least one ejector is positioned on an outer surface of the second support.

In one embodiment, an opening of an ejector of the at least one ejector is aligned substantially parallel to the length direction of the surface of the structure.

In one embodiment, an opening of an ejector of the at least one ejector is substantially aligned with a circumference of the surface of the structure.

In one embodiment, the motion apparatus is adapted to drive the structure into rotation, for example is also adapted to held the structure.

In one embodiment, the motion apparatus comprises:
- at least one rolling piece, preferably a plurality of rolling pieces, adapted to be coupled to another surface of the structure different from the surface to be coated, in such a way that the rotation of the at least one rolling piece causes the rotation of said structure; and
- at least a driving unit, like a motor, adapted to be coupled to the at least one rolling piece in order to drive it into rotation.

In one embodiment, the device comprises a heating apparatus, like a heating resistor, an ohmic heating coil or an inductive heating coil, adapted to heat the surface.

In one particular embodiment, the heating apparatus comprises a heating resistor connected to at least one rolling piece.

### Brief description of drawings

The foregoing features and advantages, as well as others, will be described in detail in the following description of specific embodiments given by way of illustration and not limitation with reference to the accompanying drawings, in which:
FIG. 1 is a general perspective view of an embodiment of a device adapted to uniform coating of an outer surface of a cylinder.
FIG. 2 is a general perspective view of another embodiment of a device adapted to uniform coating of an outer surface of a cylinder.
FIG. 3 is a general perspective view of an embodiment of a device adapted to uniform coating of an inner surface of a cylinder.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

The figure is not to scale. The drawings refer to an embodiment of the present invention for uniform coating of a surface, sometimes referred simply as coating, when no ambiguity is anticipated. Other embodiments may be possible, as someone with appropriate training may readily appreciate. The actual dimension and/or shape of each of the components of the embodiment may vary. Only important details of the embodiment are shown, however one of ordinary skill in the art can appreciate how the overall device may be constructed, without undue experimentation. Some details have been omitted from the drawing, but the inventors believe that adding these details is unnecessary for the overall appreciation of the characteristics of the invention disclosed. These omitted details include, among others, elements for holding or fixing the device or its functional components. Some characteristics of the embodiment appear exaggerated to facilitate understanding. The embodiments disclosed, and alternatives observed should not be considered as limiting the invention in any way.

In the drawings, the surface to be coated is an inner or an outer surface of a right circular cylinder. In other words, the structure is a right circular cylinder (first cylinder **110**). Other shapes of a structure having a surface to be coated are possible. In other examples, the surface to be coated could be an inner or an outer surface of a non-circular and/or non-right cylinder, or any other appropriate structure.

For the uniform coating of a surface of the first cylinder **110,** a chamber adapted to contain the first cylinder is required.

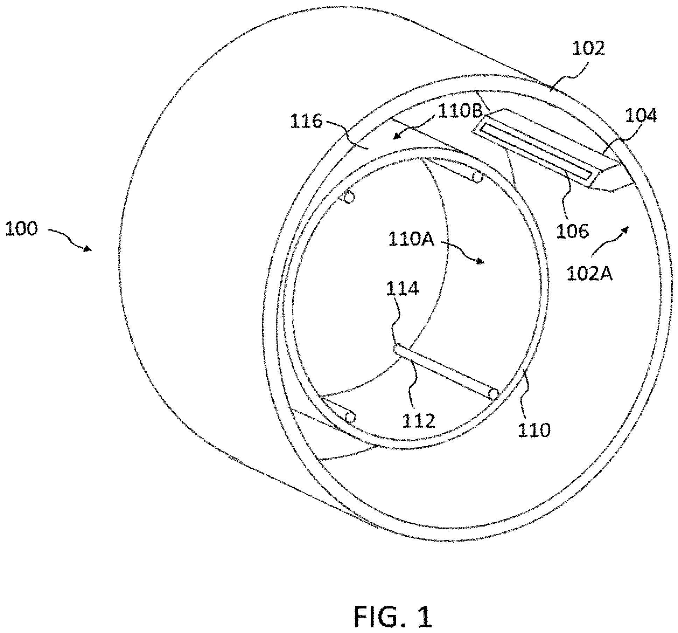

In FIG. 1, is illustrated a device **100** adapted to coating an outer surface **110B** of the first cylinder **110.** The device comprises a second cylinder **102** (first support), larger in diameter than the first cylinder **110,** the first cylinder being located inside the second cylinder during the coating. The bases of both cylinders may be aligned through their centers. For example, the cylinders may be concentric.

The second cylinder **102** is hollow, so that it has an inner surface **102A** that faces the first cylinder **110.** An ejector, for example a jet or nozzle **104** is located on the inner surface **102A** of the second cylinder **102,** so that it faces the outer surface **110B** of the first cylinder **110.** The nozzle **104** has an opening, aperture, or nozzle head **106** for expelling material at a certain velocity. The head **106** of the nozzle **104** is aligned parallel to the outer surface **110B** of the first cylinder **110.**

When reference is made to an ejector, this may include a jet or a nozzle, depending on the technique used. When reference is made to a nozzle head this also means more generally an opening or an aperture in an ejector.

In the embodiment of FIG. 1, the head **106** of the nozzle **104** is aligned with the length direction of the outer surface **110B** of the first cylinder **110** and may be oriented in order to eject vapor substantially radially.

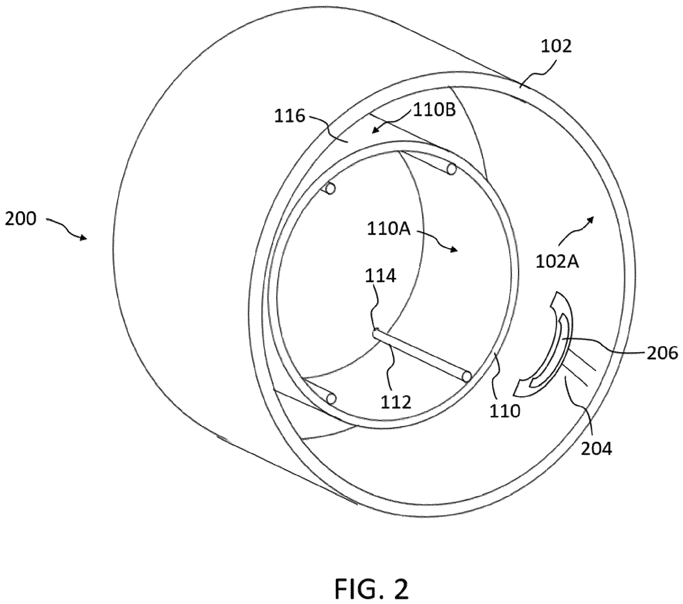

Another embodiment of a device **200** adapted to coating an outer surface **110B** of the first cylinder **110** is illustrated in FIG. 2. In this other embodiment, the nozzle **204** is also located on the inner surface **102A** of the second cylinder **102,** but the head **206** of the nozzle **204** is substantially aligned with an outer circumference of the first cylinder **110** and may be oriented in order to eject vapor substantially longitudinally. The two embodiments can be combined, that is, one or several nozzle (s) can be aligned with the length direction of the first cylinder and another or other nozzle(s) can be aligned with an outer circumference of the first cylinder.

The first cylinder **110** is held on its place by batons or rods **112.** The rods **112** rotate, allowing the first cylinder **110** to rotate as well. The base of at least a rod **112** may be fashioned with a heating resistor **114,** that would heat the rod **112** and in turn the first cylinder **110.** Besides a heating resistor **114** other means for heating may also be used, other embodiments may use effects like direct ohmic heating or inductive heating and appropriate coils or apparatus for such. The rods **112** could act as electrodes used to pass current through the first cylinder **110** in order to heat it.

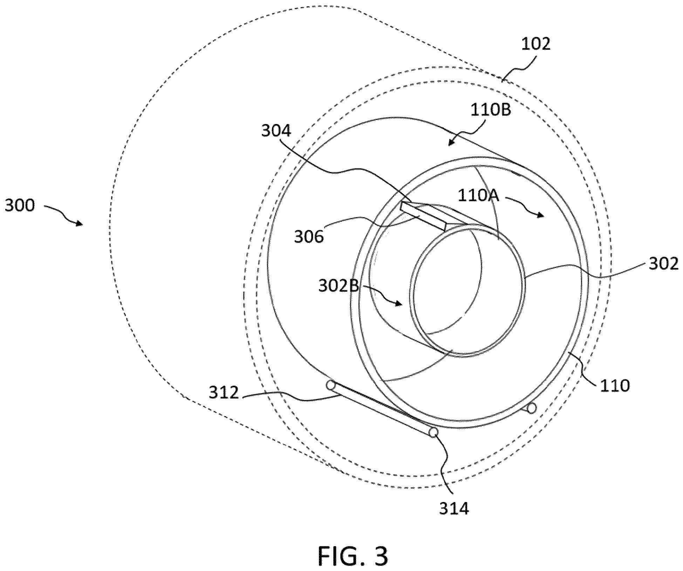

In the device **100** of FIG. 1 or the device **200** of FIG. 2 adapted to coating an outer surface **110B** of a first cylinder **110,** the rods **112** are preferably located on an inner surface **110A** of said first cylinder, or on a surface that allow coating the outer surface of the first cylinder. Another embodiment of a device adapted to coating an inner surface of the first cylinder, in which the rods are located on an outer surface of the first cylinder, is illustrated in FIG. 3 and described later.

In one embodiment, at least a base (if the other base is already closed), or the two bases, of the second cylinder **102** may be closed so that the first cylinder **110** may be enclosed inside the second cylinder **102.** This arrangement may be called an enclosure, vault, or chamber. The second cylinder may form the chamber. In another embodiment, the first and second cylinders may be placed in a chamber, different from the second cylinder.

### Example of operation

In order to uniformly coat the first cylinder **110** through the use of vapor deposition, said first cylinder of FIG. 1 or FIG.2 must be enclosed in a chamber as described above, and a vacuum must preferably be created so that no air or other gas surrounds the first cylinder **110.** If the material or precursor is not already in the form of vapor, the material or precursor to be deposited must be evaporated and injected through the nozzle **104, 204.** The vapor is then ejected through the nozzle head **106, 206** at an appropriate speed and at a direction substantially parallel, oblique, or substantially radially to the outer surface **110B** of the first cylinder **110.** For example, for an advanced metal-organic chemical vapor deposition (MOCVD) coating, a substantially parallel ejection is desirable, whereas for a regular MOCVD coating, or a chemical vapor deposition (CVD), an oblique ejection or even a substantially radially ejection may be sufficient.

In tandem with the ejection of the vapor, the first cylinder **110** is rotated by means of the rods **112.** Because the second cylinder **102** is not moving, the first cylinder **110** is moving relative to it. Therefore, the phenomenon known as Couette flow may be observed, and a specific velocity profile can be made to exist in between the outer surface **110B** of the first cylinder **110** and the inner surface **102A** of the second cylinder **102.** By changing the relative velocity of the cylinders, this profile can be configured to create laminar flow, which would be highly desirable in some chemical vapor deposition applications. Laminar flow would ensure uniform coating of outer surface **110B** of the first cylinder **110.**

For certain applications, it may be necessary for the outer surface **110B** of the first cylinder **110** to be at a certain temperature, this may ensure that the material deposits accurately over the surface of this cylinder **110.** In an embodiment, a buffer **116** layer may be located on the outer surface **110B** of the first cylinder **110** and that layer would have to be heated to a high temperature to accept the vapor deposition, for example more than 500°C, for example in the range from 500°C to 900°C.

In Fig. 3, is illustrated another device **300** adapted to coating an inner surface **110A** of the first cylinder **110.**

The device **300** comprises a third cylinder **302** (second support) adapted to be positioned inside the first cylinder **110.** Therefore, the third cylinder has a diameter smaller than the diameter of the first cylinder. The bases of the first and third cylinders may be aligned through their centers. For example, the first and third cylinders may be concentric.

An ejector, for example a jet or nozzle **304** is located on the outer surface **302B** of the second cylinder **302,** so that it faces the inner surface **110A** of the first cylinder **110.** The nozzle **304** has an opening, aperture, or nozzle head **306** for expelling material at a certain velocity. The head **306** of the nozzle **304** is aligned parallel to the inner surface **110A** of the first cylinder **110.**

In the embodiment of FIG. 3, the head **306** of the nozzle **304** is substantially aligned with the length direction of the inner surface **110A** of the first cylinder **110,** and may be oriented in order to eject vapor substantially radially. In another embodiment, similar to that of FIG. 2, the head of the nozzle may be substantially aligned with an inner circumference of the first cylinder, and may be oriented in order to eject vapor substantially longitudinally. The two embodiments can be combined, that is, one or several nozzle(s) can be aligned with the length direction of the first cylinder and another or other nozzle(s) can be aligned with an inner circumference of the first cylinder.

The first cylinder **110** is held on its place by batons or rods **312.** The rods **312** rotate, allowing the small cylinder **110** to rotate as well. The base of at least a rod **312** may be fashioned with a heating resistor **314,** that would heat the rod **312** and in turn the first cylinder **110.** Besides heating resistor **314** other means for heating may also be used, other embodiments may use effects like direct ohmic heating or inductive heating and appropriate coils or apparatus for such. The rods **312** could act as electrodes used to pass current through the first cylinder **110** in order to heat it.

In the device **300** of FIG. 3, the rods **312** are preferably located on an outer surface **110B** of said first cylinder, or may be located on another surface that allow coating the inner surface of the first cylinder.

The second cylinder **102** may not be present in the device **300.** For example, the first and third cylinder may be placed in a chamber that may not necessarily be a right circular cylinder, or even not necessarily a cylinder. As another example, the first cylinder may be closed before coating to form a chamber.

The third cylinder may be a cylinder in its broader definition, that is, not necessarily right circular, or even have a shape different from a cylinder.

Other features described in FIG. 1 or 2 may apply to the device of FIG. 3.

The example of operations described above may apply to the embodiment of FIG. 3, and may require some adaptations accessible to a person skilled in the art.

An application of the embodiments can be the manufacturing of superconductive coils, in particular modular coils. To form a superconductive coil, the structure, for example a cylinder, may be coated with different appropriate layers, forming a stacking of layers, and at least a superconducting layer, using different techniques, as described for example in European patent application number EP22305437, filed on April 4, 2022 by the same applicant "RENAISSANCE FUSION", entitled "METHOD FOR MANUFACTURING SUPERCONDUCTING COILS AND DEVICE", which is hereby incorporated by reference to the maximum extent allowable by law. In addition, a step of removing material from the layers may be provided, in order to create patterns that form grooves in the coated cylinder. The patterns may depend on the application. In order to remove the material, a technique like laser patterning may be used, or other techniques, like a mechanical technique or photolithography may be used. The grooves may be filled with a metal, for example silver. The cylinder of the superconducting coil may be machined to have a particular shape, and the superconducting coil may be assembled to another superconducting coil, of a similar or a different shape, like several modular coils, to form an assembly. For example, several superconducting coils may be assembled to form a stellarator.

Example embodiments of the invention are summarized here. Other embodiments can also be understood from the entirety of the specification as well as the claims filed herein.

Example 1. A method for coating a surface (110B; 110A) of a structure (110), the method comprising steps of:
- placing a structure (110) inside a chamber, at least one ejector (104; 204; 304) being located inside the chamber and oriented towards a surface (110B; 110A) to be coated of the structure;
- enclosing the chamber;
- forming a vacuum in the chamber; and then
- injecting vapor through the at least one ejector (104; 204; 304) towards the surface, while causing a relative motion, for example rotation, between the structure and the at least one ejector.

Example 2. The method according to example 1, wherein a material, for example a precursor, is evaporated to form the vapor, before the injection step.

Example 3. The method according to example 1 or 2, wherein the method further comprises heating the surface (110B; 110A) of the structure (110), preferably at a first temperature, preferably a high temperature, for example higher than 500°C.

Example 4. The method according to example 3, wherein a buffer layer (116) is located on the surface (110B; 110A), the buffer layer being heated at the first temperature.

Example 5. The method according to any one of examples 1 to 4, wherein the velocity of the motion, for example rotation, is adapted to creating a laminar flow of the vapor near the surface (110B; 110A) in the chamber.

Example 6. The method according to any one of examples 1 to 5, wherein causing a relative motion between the structure and the ejector comprises, for example consists in, rotating said structure.

Example 7. The method according to any one of examples 1 to 6, wherein the vapor is injected at a direction substantially parallel to the surface (110B; 110A) of the structure (110), and/or wherein the vapor is injected at a direction oblique, for example substantially radially, to the surface (110B; 110A) of the structure (110).

Example 8. A device (100; 200; 300) for coating a surface (110B; 110A) of a structure (110), adapted to implement the method of any of examples 1 to 7, wherein the device comprises:
- a chamber adapted to contain a structure;
- at least one ejector (104; 204; 304) located inside the chamber and oriented towards a surface (110B; 110A) to be coated of the structure, the ejector being adapted to injecting vapor towards said surface; and
- a motion apparatus adapted to cause a relative motion, for example rotation, between said structure and the at least one ejector.

Example 9. The device (100; 200; 300) according to example 8, wherein the device comprises a first and/or second support (102; 302) contained in the chamber or forming at least part of the chamber, and adapted to support the at least one ejector (104; 204; 304), the first and/or second support being for example a cylinder.

Example 10. The device (100; 200) according to example 9, wherein the surface to be coated is an outer surface (110B) of the structure (110), the device comprises a first support (102) adapted to contain the structure, and an ejector (104; 204) of the at least one ejector is positioned on an inner surface (102A) of the first support (102).

Example 11. The device according to example 10, wherein the first support (102) forms at least part of the chamber, for example the first support (102) comprises at least a base adapted to be closed in order to enclose the structure (110) inside said first support.

Example 12. The device (300) according to example 9, wherein the surface to be coated is an inner surface (110A) of the structure (110), the device comprises a second support (302) adapted to be placed inside the structure, and an ejector (304) of the at least one ejector is positioned on an outer surface (302B) of the second support.

Example 13. The device (100) according to any one of examples 8 to 12, wherein an opening (106; 304) of an ejector (104; 304) of the at least one ejector is aligned substantially parallel to the length direction of the surface (110B; 110A) of the structure (110).

Example 14. The device (200) according to any one of examples 8 to 13, wherein an opening (206) of an ejector (204) of the at least one ejector is substantially aligned with a circumference of the surface (110B) of the structure (110).

Example 15. The device according to any one of examples 8 to 14, wherein the motion apparatus is adapted to drive the structure (110) into rotation, for example is also adapted to held the structure.

Example 16. The device according to example 15, wherein the motion apparatus comprises:
- at least one rolling piece (112; 312), preferably a plurality of rolling pieces, adapted to be coupled to another surface (110A; 110B) of the structure different from the surface (110B; 110A) to be coated, in such a way that the rotation of the at least one rolling piece causes the rotation of said structure; and
- at least a driving unit, like a motor, adapted to be coupled to the at least one rolling piece in order to drive it into rotation.

Example 17. The device according to example 16, wherein the at least one rolling piece (112; 312) is a baton, a rod, a disc, a cylinder, or a wheel.

Example 18. The device according to any one of examples 8 to 17, wherein the device comprises a heating apparatus (114; 314), like a heating resistor, an ohmic heating coil or an inductive heating coil, adapted to heat the surface (110B; 110A).

Example 19. The device according to example 18 in combination with example 16 or 17, wherein the heating apparatus comprises a heating resistor (114; 314) connected to at least one rolling piece (112; 312).

Example 20. The device according to any one of examples 8 to 19, or the method according to any one of examples 1 to 7, wherein the structure (110) is a cylinder.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

### List of acronyms:

- HTS: High-Temperature Superconductors
- MOCVD: Metal-organic Chemical Vapor Deposition
- CVD: Chemical Vapor Deposition

## Claims

1. A method for coating a surface (110B; 110A) of a structure (110), the method comprising steps of:
- placing a structure (110) inside a chamber, at least one ejector (104; 204; 304) being located inside the chamber and oriented towards a surface (110B; 110A) to be coated of the structure;
- enclosing the chamber;
- forming a vacuum in the chamber; and then
- injecting vapor through the at least one ejector (104; 204; 304) towards the surface, while causing a relative motion, for example rotation, between the structure and the at least one ejector.

2. The method according to claim 1, wherein a material, for example a precursor, is evaporated to form the vapor, before the injection step.

3. The method according to claim 1 or 2, wherein the method further comprises heating the surface (110B; 110A) of the structure (110), preferably at a first temperature, preferably a high temperature, for example higher than 500°C.

4. The method according to claim 3, wherein a buffer layer (116) is located on the surface (110B; 110A), the buffer layer being heated at the first temperature.

5. The method according to any one of claims 1 to 4, wherein the velocity of the motion, for example rotation, is adapted to creating a laminar flow of the vapor near the surface (110B; 110A) in the chamber.

6. The method according to any one of claims 1 to 5, wherein causing a relative motion between the structure and the ejector comprises, for example consists in, rotating said structure.

7. The method according to any one of claims 1 to 6, wherein the vapor is injected at a direction substantially parallel to the surface (110B; 110A) of the structure (110), and/or wherein the vapor is injected at a direction oblique, for example substantially radially, to the surface (110B; 110A) of the structure (110).

8. A device (100; 200; 300) for coating a surface (110B; 110A) of a structure (110), adapted to implement the method of any of claims 1 to 7, wherein the device comprises:
- a chamber adapted to contain a structure (110);
- at least one ejector (104; 204; 304) located inside the chamber and oriented towards a surface (110B; 110A) to be coated of the structure, the ejector being adapted to injecting vapor towards said surface; and
- a motion apparatus adapted to cause a relative motion, for example rotation, between said structure and the at least one ejector.

9. The device (100; 200; 300) according to claim 8, wherein the device comprises a first and/or second support (102; 302) contained in the chamber or forming at least part of the chamber, and adapted to support the at least one ejector (104; 204; 304), the first and/or second support being for example a cylinder.

10. The device (100; 200) according to claim 9, wherein the surface to be coated is an outer surface (110B) of the structure (110), the device comprises a first support (102) adapted to contain the structure, and an ejector (104; 204) of the at least one ejector is positioned on an inner surface (102A) of the first support (102).

11. The device according to claim 10, wherein the first support (102) forms at least part of the chamber, for example the first support (102) comprises at least a base adapted to be closed in order to enclose the structure (110) inside said first support.

12. The device (300) according to claim 9, wherein the surface to be coated is an inner surface (110A) of the structure (110), the device comprises a second support (302) adapted to be placed inside the structure, and an ejector (304) of the at least one ejector is positioned on an outer surface (302B) of the second support.

13. The device (100) according to any one of claims 8 to 12, wherein an opening (106; 304) of an ejector (104; 304) of the at least one ejector is aligned substantially parallel to the length direction of the surface (110B; 110A) of the structure (110).

14. The device (200) according to any one of claims 8 to 13, wherein an opening (206) of an ejector (204) of the at least one ejector is substantially aligned with a circumference of the surface (110B) of the structure (110).

15. The device according to any one of claims 8 to 14, wherein the motion apparatus is adapted to drive the structure (110) into rotation, for example is also adapted to held the structure.

16. The device according to claim 15, wherein the motion apparatus comprises:
- at least one rolling piece (112; 312), preferably a plurality of rolling pieces, adapted to be coupled to another surface (110A; 110B) of the structure different from the surface (110B; 110A) to be coated, in such a way that the rotation of the at least one rolling piece causes the rotation of said structure; and
- at least a driving unit, like a motor, adapted to be coupled to the at least one rolling piece in order to drive it into rotation.

17. The device according to any one of claims 8 to 16, wherein the device comprises a heating apparatus (114; 314), like a heating resistor, an ohmic heating coil or an inductive heating coil, adapted to heat the surface (110B; 110A) .

18. The device according to claim 17 in combination with claim 16, wherein the heating apparatus comprises a heating resistor (114; 314) connected to at least one rolling piece (112; 312).
